# FASCICULE DE BREVET EUROPEEN

(11) **EP 1 728 273 B1**
(45) Date de publication et mention de la délivrance du brevet: **03.04.2013**
(21) Numéro de dépôt: 05744616.3
(22) Date de dépôt: 25.03.2005
(51) Int. Cl.: H01L 29/165, H01L 29/205, H01L 29/267, H01L 29/78, H01L 27/092, H01L 21/336

(54) **TRANSISTOR A MATERIAUX DE SOURCE, DE DRAIN ET DE CANAL ADAPTES ET CIRCUIT INTEGRE COMPORTANT UN TEL TRANSISTOR**
TRANSISTOR MIT ANGEPASSTEN SOURCE-, DRAIN- UND KANALMATERIALIEN UND INTEGRIERTE SCHALTUNG MIT EINEM SOLCHEN TRANSISTOR
TRANSISTOR WITH ADAPTED SOURCE, DRAIN AND CHANNEL MATERIALS AND INTEGRATED CIRCUIT COMPRISING SAME

(30) Priorité: 25.03.2004 FR 0403066
(43) Date de publication de la demande: 06.12.2006
(73) Titulaire: Commissariat à l'Énergie Atomique et aux Énergies Alternatives, 75015 Paris (FR)
(72) Inventeur: DELEONIBUS, Simon, F-38640 Claix (FR)
(74) Mandataire: Hecké, Gérard
(86) Numéro de dépôt international: PCT/FR2005/000720
(87) Numéro de publication internationale: WO 2005/093812

(56) Documents cités:
- US-A1- 2001 020 725
- US-A1- 2004 014 276
- US-B1- 6 187 641
- PATENT ABSTRACTS OF JAPAN vol. 0123, no. 69 (E-665), 4 octobre 1988 (1988-10-04) & JP 63 122177 A (NIPPON TELEGR & TELEPH CORP <NTT>), 26 mai 1988 (1988-05-26)
- SUBRAMANIAN V ET AL: "A Novel Technique For 3-d Integration: Ge-seeded Laterally Crystallized TFTs" 1997 SYMPOSIUM ON VLSI TECHNOLOGY - DIGEST OF TECHNICAL PAPERS, 10 juin 1997 (1997-06-10), pages 97-98, XP010245825
- PATENT ABSTRACTS OF JAPAN vol. 0122, no. 17 (E-624), 21 juin 1988 (1988-06-21) & JP 63 013379 A (NIPPON TELEGR & TELEPH CORP <NTT>), 20 janvier 1988 (1988-01-20)
- UNDERT N ET AL: "Quasi-planar FinFETs with selectively grown Germanium raised source/drain" 2001 IEEE INTERNATIONAL SOI CONFERENCE PROCEEDINGS. DURANGO, CO, OCT. 1 - 4, 2001, IEEE INTERNATIONAL SOI CONFERENCE, NEW YORK, NY : IEEE, US, 1 octobre 2001 (2001-10-01), pages 111-112, XP010563655 ISBN: 0-7803-6739-1
- PATENT ABSTRACTS OF JAPAN vol. 0133, no. 52 (E-801), 8 août 1989 (1989-08-08) & JP 01 112772 A (FUJITSU LTD), 1 mai 1989 (1989-05-01)
- PATENT ABSTRACTS OF JAPAN vol. 0111, no. 30 (E-502), 23 avril 1987 (1987-04-23) & JP 61 276265 A (NEC CORP), 6 décembre 1986 (1986-12-06)

## Description

### Domaine technique de l'invention

L'invention concerne un transistor à effet de champ comportant une source, un drain et un canal, constitués respectivement par des matériaux de source, de drain et de canal, les matériaux de source, de drain et de canal étant choisis de manière à ce que, pour un transistor de type NMOS du type normalement passant, l'affinité électronique Xd du matériau de drain soit inférieure à l'affinité électronique Xc du matériau de canal et l'affinité electronique X_{S} du matériau de source est supérieure et l'affinité electronique X_{C} du materiau de canal; et de manière à ce que, pour un transistor de type PMOS du type normalement passant, le niveau supérieur Ed de la bande de valence du matériau de drain soit supérieur au niveau supérieur Ec de la bande de valence du matériau de canal et le niveau supérieur E_{S} de la bande de valence du matériau de source est inférieur au niveau supérieur de la bande de valence du matériau de canal.

### État de la technique

Les transistors à effet de champ réalisés sur film mince comportent classiquement une source et un drain reliés par un canal commandé par une électrode de grille. Les porteurs de charge sont ralentis par diffusion lors de leurs passages dans le canal, d'une part, et entre la source et le canal, d'autre part, ce qui limite la vitesse de commutation du transistor. Typiquement, pour résoudre ce problème, les zones de la source et du drain sont fortement dopées, ce qui nécessite une très forte activation des dopants dans les matériaux de source et de drain. Si ces matériaux sont semi-conducteurs, l'activation des dopants est plafonnée par la solubilité chimique limite des dopants dans les matériaux.

L'utilisation d'un canal en silicium et d'une source et/ou d'un drain en germanium est bien connue. Le document JP63122177, par exemple, décrit un transistor du type MOS comportant un canal en germanium et des électrodes de source et de drain comportant chacune une couche de germanium et une couche de silicium, dopées N ou P. Le canal peut être un canal de type N ou P. Le document propose l'utilisation du transistor dans un circuit CMOS.

Le document JP63013379 décrit un transistor comportant un canal en silicium et des électrodes de source et de drain constitués chacune d'une couche de germanium dopée N et déposée sur du silicium.

Le document US2004/0014276 décrit des transistors NMOS et PMOS comportant chacun un canal en silicium et des source et drain en germanium.

L'article "Quasi-Planar FinFETs with Selectively Grown Germanium Raised Source/Drain" de Lindert et al. décrit un transistor à effet de champ ayant un liaison étroite ("fin") entre la source et le drain. La liaison étroite constitue le canal. Le canal est en silicium et l'un des source et drain peut être en germanium.

### Objet de l'invention

L'invention a pour but de remédier à ces inconvénients et, en particulier, de réaliser des transistors permettant un fonctionnement plus rapide.

Selon l'invention, ce but est atteint par les revendications annexées.

L'invention a également pour but un circuit intégré, comportant des transistors à effet de champ de type PMOS et de type NMOS selon l'invention.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

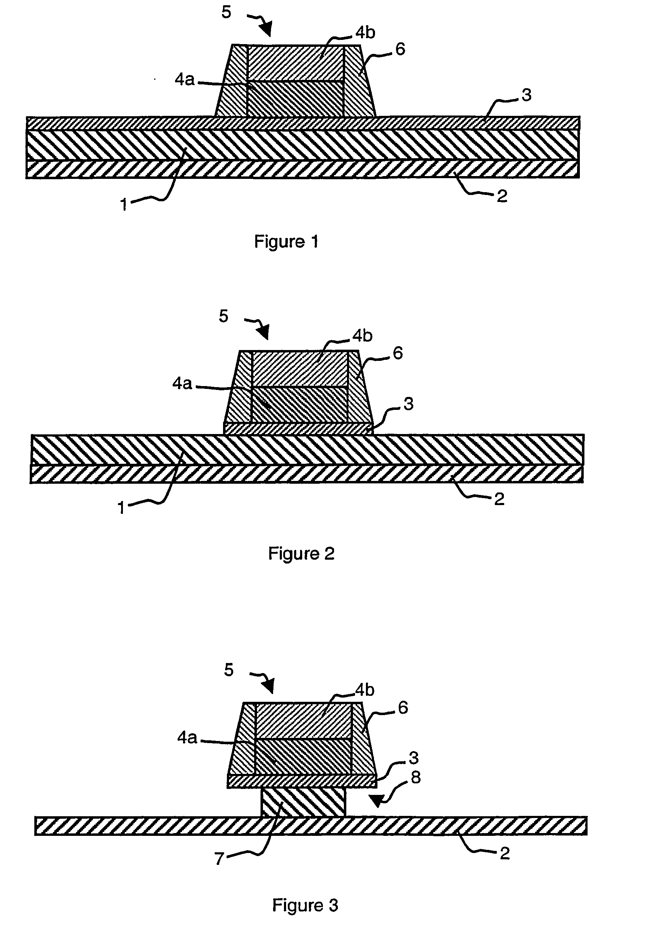

Les figures 1 à 5 illustrent un mode de réalisation particulier d'un procédé de réalisation d'un transistor selon l'invention.

### Description de modes particuliers de réalisation

Les transistors selon l'invention comportent chacun un canal en un matériau prédéterminé, par exemple du silicium (Si), du germanium (Ge), du carbone diamant (C diamant), de l'arséniure de gallium (GaAs) ou de l'antimoniure d'indium (InSb).

Selon l'invention, les matériaux de source et de drain des transistors NMOS sont choisis en fonction de leurs affinités électroniques Xs et Xd, tandis que pour les transistors PMOS, les matériaux de source et de drain sont choisis en fonction de leurs niveaux supérieurs Es et Ed de la bande de valence.

Le matériau de drain d'un transistor NMOS est choisi de manière à ce que l'affinité électronique Xd du matériau de drain soit inférieure à l'affinité électronique Xc du matériau de canal dudit transistor NMOS (Xd<Xc). Le matériau de drain d'un transistor PMOS est choisi de manière à ce que le matériau de drain ait un niveau supérieur Ed de la bande de valence qui est supérieur au niveau supérieur Ec de la bande de valence du matériau de canal dudit transistor PMOS (Ed>Ec).

L'invention s'applique aussi plus particulièrement à la réalisation d'un circuit intégré comportante des transistors à effet de champ de type PMOS et des transistors de type NMOS selon l'invention.

Des transistors NMOS et PMOS sont des transistors du type normalement passant, indiqué par la suite par la référence (on) (abréviation du terme anglais «normally on»), ou du type normalement bloqué, indiqué par la suite par la référence (off) (abréviation du terme anglais «normally off»). Dans les deux cas (on et off), le matériau de drain est choisi en appliquant les règles précédentes respectivement aux transistors NMOS et PMOS. Pour le matériau de source, on choisit un autre matériau que celui du canal. Les transistors du type normalement bloqué ne font pas partie de l'invention. Par la suite on se limite donc, pour le choix du matériau de source, aux transistors normalement passants (on).

Pour des transistors de type normalement passant, le matériau de source d'un transistor NMOS est choisi de manière à ce que l'affinité électronique Xs(on) du matériau de source soit supérieure à l'affinité électronique Xc(on) du matériau de canal dudit transistor NMOS (Xs(on)>Xc(on)). Le niveau supérieur Es(on) de la bande de valence du matériau de source d'un transistor PMOS, normalement passant, est inférieur au niveau supérieur Ec(on) de la bande de valence du matériau de canal dudit transistor PMOS (Es(on)<Ec(on)).

Ces règles permettent d'adapter les matériaux de drain et de source au matériau de canal de manière à rendre le transistor plus performant. En particulier, en choisissant un matériau de source adapté différent de celui du canal, la vitesse des porteurs de charge dans le canal est alors automatiquement supérieure à la vitesse de dérive de référence qui est la vitesse obtenue si le matériau de la source est de même nature chimique que le matériau du canal mais fortement dopé de type inverse. De plus, la vitesse des porteurs de charge dans la source est supérieure à la vitesse des porteurs dans le canal. Le matériau de drain est différent du matériau de canal et le matériau de source est différent du matériau de canal. Les matériaux de source et de drain sont également différents entre eux.

Le tableau 1 indique, en électronvolt, l'affinité électronique X et le niveau supérieur E de la bande de valence de différents matériaux pouvant être utilisés pour la réalisation de transistors à effet de champ.

**Tableau 1**

| Matériau | Affinité électronique X | Niveau supérieur E de la bande de valence |
|---|---|---|
| Si | -4,05 | -5,17 |
| Ge | -4,13 | -4,79 |
| GaAs | -4,07 | -5,49 |
| C diamant | 0 | -5,47 |
| InSb | -4,59 | -4,75 |

Pour les transistors NMOS, lorsque le canal est, par exemple, en silicium (affinité électronique X de -4,05eV), le drain peut être, par exemple, en germanium (X=-4,13eV), en arséniure de gallium (X=-4,07eV) ou en antimoniure d'indium (X=-4,59eV). Dans tous les cas, l'affinité électronique Xd du matériau de drain est ainsi inférieure à l'affinité électronique Xc du matériau de canal (Xd<Xc). Pour un transistor NMOS normalement passant, le canal étant en silicium, la source peut, par exemple, être en carbone diamant (affinité électronique X de 0eV). Ainsi, l'affinité électronique Xs(on) du matériau de source est supérieure à l'affinité électronique Xc(on) du matériau de canal (Xs(on)>Xc(on)).

Le tableau 2 indique différentes combinaisons préférentielles de matériaux de source et de drain pour un matériau de canal donné d'un transistor NMOS normalement passant.

**Tableau 2**

| Matériau de canal | Matériau de source N | Matériau de drain N |
|---|---|---|
| Si | C diamant | Ge, GaAs, InSb |
| Ge | Si, GaAs, C diamant | InSb |
| GaAs | C diamant, Si | Ge, InSb |
| C diamant | - | Si, Ge, GaAs, InSb |
| InSb | Si, Ge, GaAs, C diamant | - |

Pour les transistors PMOS, lorsque le canal est, par exemple, en silicium (niveau supérieur E de la bande de valence de-5,17eV), le drain peut être, par exemple, en germanium (E=-4,79eV) ou en antimoniure d'indium (E=-4,75eV). Dans tous les cas, le niveau supérieur Ed de la bande de valence du matériau de drain est ainsi supérieur à celui (Ec) du matériau de canal (Ed>Ec). Pour un transistor PMOS normalement passant, le canal étant en silicium, la source peut, par exemple, être en arséniure de gallium (E=-5,49eV) ou en carbone diamant (E=-5,47eV), ce qui correspond à la condition Es(on)<Ec(on).

Le tableau 3 indique différentes combinaisons préférentielles de matériaux de source et de drain pour un matériau de canal donné d'un transistor PMOS normalement passant.

**Tableau 3**

| Matériau de canal | Matériau de source P | Matériau de drain P |
|---|---|---|
| Si | GaAs, C diamant | Ge, InSb |
| Ge | Si, GaAs, C diamant | InSb |
| GaAs | - | Si, Ge, C diamant, InSb |
| C diamant | GaAs | Si, Ge, InSb |
| InSb | Si, Ge, GaAs, C diamant | - |

L'invention n'est pas limitée aux combinaisons de matériaux indiquées ci-dessus, mais s'applique quels que soient les matériaux susceptibles de former un canal, une source ou un drain d'un transistor à effet de champ, dès lors que les deux conditions précitées sont remplies. Les matériaux de source et de drain peuvent également être dopés ou non afin d'améliorer encore les performances du transistor.

Dans un mode de réalisation particulier d'un procédé de réalisation d'un transistor selon l'invention, une première couche 1 destiné à constituer le canal est déposée sur un substrat 2, comme représenté à la figure 1. Le substrat peut comporter, à sa surface, une couche mince isolante, par exemple une couche en oxyde ayant une forte constante diélectrique, par exemple de l'alumine. Puis, on dépose une couche isolante de grille 3 sur la première couche 1. Ensuite, une couche conductrice 4 est déposée sur la couche isolante de grille 3. Comme représenté à la figure 1, la couche conductrice 4 peut être constituée par la superposition d'une première couche 4a conductrice et d'une seconde couche 4b, conductrice ou non, qui peut être utilisée comme couche de masquage à la gravure. La couche 4a conductrice peut être déposée par dépôt chimique en phase gazeuse basse pression ou par épitaxie. Une étape de gravure permet de délimiter la couche conductrice 4 latéralement, par l'intermédiaire d'un masque (non-représenté), de manière à former l'électrode de grille 5. Ensuite, le dépôt d'un matériau isolant sur les flancs de l'électrode de grille 5 permet de constituer un isolant latéral 6 de l'électrode de grille 5. L'isolant électrique latéral 6 peut être réalisé par dépôt, autour de l'électrode de grille 5, d'une couche ayant une épaisseur correspondant à l'épaisseur de la couche conductrice 4, suivi par une gravure par l'intermédiaire d'un masque (non-représenté).

Sur la figure 2 est représentée la gravure de la couche isolante de grille 3 dans les zones du substrat 2 non recouvertes par l'électrode de grille 5 et l'isolant 6. Cette gravure peut être réalisée en utilisant des mélanges chlorés et une technique de type cathode chaude.

La gravure de la première couche 1, représentée à la figure 3, permet de délimiter latéralement le canal 7. La première couche 1 peut être gravée par gravure anisotrope ou isotrope, comme représenté à la figure 3. Par gravure isotrope, on obtient un retrait 8 de la première couche 1 sous la couche isolante de grille 3, de préférence jusque sous l'électrode de grille 5. La gravure anisotrope peut être effectuée par gravure ionique réactive.

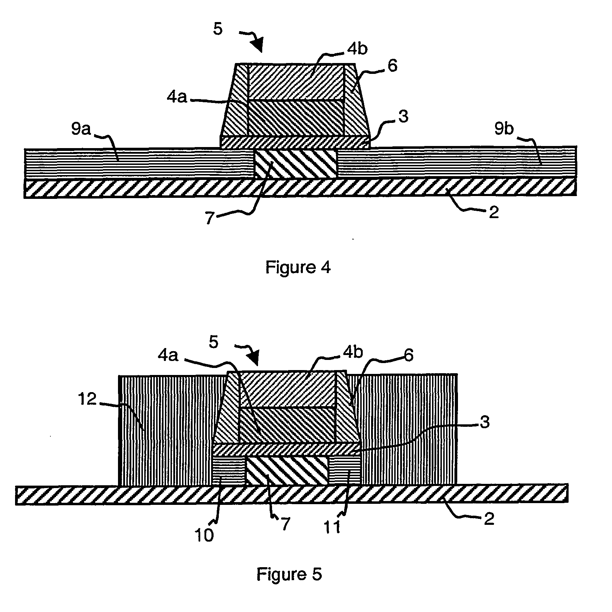

Sur la figure 4 est représenté le dépôt sur le substrat 2, de part et d'autre du canal 7, par exemple par épitaxie, des matériaux de source 9a et de drain 9b, destinés à constituer respectivement la source et le drain.

Une gravure anisotrope des matériaux de source 9a et de drain 9b dans les zones du substrat 2 non recouvertes par l'électrode de grille 5 et l'isolant latéral 6 permet de délimiter latéralement les matériaux de source 9a et de drain 9b et de former la source 10 et le drain 11, comme représenté à la figure 5. La gravure du matériau semi-conducteur permet en particulier d'obtenir un transistor de faible taille. La fabrication du transistor se termine par la formation d'éléments de contact reliés à la source 10 et au drain 11, par dépôt d'un métal 12 sur le substrat 2, planarisation, par exemple par voie mécano-chimique, et gravure du métal 12.

Lorsque la source 10 et le drain 11 d'un transistor sont constitués de matériaux différents, le procédé de fabrication du transistor comporte, de préférence, le dépôt, sur le substrat 2, à l'emplacement destiné au drain 11, d'un premier masque et le dépôt, sur le substrat 2, du matériau de source 9a. Le premier masque peut être, par exemple, un masque minéral en silice (SiO₂), déposé par dépôt chimique en phase gazeuse. Le dépôt du matériau de source 9a peut être réalisé par épitaxie. Ensuite, le premier masque est retiré, par exemple par l'intermédiaire d'une solution d'acide fluorhydrique (HF), et un second masque, par exemple en silice, est déposé sur le matériau de source 9a. Puis, le matériau de drain 9b est déposé, par exemple par épitaxie, et le second masque est retiré. On peut ensuite graver de façon anisotrope les matériaux 9a et 9b pour délimiter respectivement la source 10 et le drain 11, comme précédemment. Le transistor ainsi obtenu peut être enrobé par une couche épaisse en silice, dans laquelle on forme les contacts.

## Revendications

1. Transistor à effet de champ comportant une source, un drain et un canal, constitués respectivement par des matériaux de source, de drain et de canal, les matériaux de source, de drain et de canal étant choisis de manière à ce que, pour un transistor de type NMOS, l'affinité électronique (Xd) du matériau de drain soit inférieure à l'affinité électronique (Xc) du matériau de canal, transistor **caractérisé en ce que**, le transistor étant du type normalement passant, l'affinité électronique (Xs) du matériau de source d'un transistor NMOS est supérieure à l'affinité électronique (Xc) du matériau de canal dudit transistor NMOS.

2. Transistor à effet de champ comportant une source, un drain et un canal, constitués respectivement par des matériaux de source, de drain et de canal, les matériaux de source, de drain et de canal étant choisis de manière à ce que, pour un transistor de type PMOS, le niveau supérieur (Ed) de la bande de valence du matériau de drain soit supérieur au niveau supérieur (Ec) de la bande de valence du matériau de canal, transistor **caractérisé en ce que**, le transistor étant du type normalement passant, le niveau supérieur (Es) de la bande de valence du matériau de source d'un transistor PMOS est inférieur au niveau supérieur (Ec) de la bande de valence du matériau de canal dudit transistor PMOS.

3. Circuit intégré, **caractérisé en ce qu'**il comporte des transistors à effet de champ de type PMOS selon la revendication 2 et de type NMOS selon la revendication 1.

## Claims

1. Field effect transistor comprising a source, a drain and a channel, respectively formed by source, drain and channel materials, the source, drain and channel materials being selected such that, for a NMOS type transistor, the electronic affinity (Xd) of the drain material is lower than the electronic affinity (Xc) of the channel material, transistor **characterized in that**, the transistor being of the normally on type, the electronic affinity (Xs) of the source material of a NMOS transistor is higher than the electronic affinity (Xc) of the channel material of said NMOS transistor.

2. Field effect transistor comprising a source, a drain and a channel, respectively formed by source, drain and channel materials, the source, drain and channel materials being selected such that, for a PMOS type transistor, the upper level (Ed) of the valence band of the drain material is higher than the upper level (Ec) of the valence band of the channel material, transistor **characterized in that**, the transistor being of the normally on type, the upper level (Es) of the valence band of the source material of a PMOS transistor is lower than the upper level (Ec) of the valence band of the channel material of said PMOS transistor.

3. Integrated circuit, **characterized in that** it comprises PMOS type field effect transistors according to claim 2 and NMOS type field effect transistors according to claim 1.

## Patentansprüche

1. Feldeffekttransistor, umfassend eine Source, einen Drain und einen Kanal, die durch Source-, Drain- bzw. Kanalmaterialien gebildet sind, wobei die Source-, Drain-und Kanalmaterialien derart gewählt sind, dass bei einem Transistor vom Typ NMOS die Elektronenaffinität (Xd) des Drainmaterials niedriger als die Elektronenaffmität (Xc) des Kanalmaterials ist, Transistor, der **dadurch gekennzeichnet ist, dass** wenn der Transistor vom normalerweise durchlassenden Typ ist, die Elektronenaffinität (Xs) des Sourcematerials eines NMOS-Transistors größer als die Elektronenaffinität (Xc) des Kanalmaterials des NMOS-Transistors ist.

2. Feldeffekttransistor, umfassend eine Source, einen Drain und einen Kanal, die durch Source-, Drain- bzw. Kanalmaterialien gebildet sind, wobei die Source-, Drain-und Kanalmaterialien derart gewählt sind, dass bei einem Transistor vom Typ PMOS das obere Niveau (Ed) des Valenzbandes des Drainmaterials höher als das obere Niveau (Ec) des Valenzbandes des Kanalmaterials ist, Transistor, der **dadurch gekennzeichnet ist, dass** wenn der Transistor vom normalerweise durchlassenden Typ ist, das obere Niveau (Es) des Valenzbandes des Sourcematerials eines PMOS-Transistors niedriger als das obere Niveau (Ec) des Valenzbandes des Kanalmaterials des PMOS-Transistors ist.

3. Integrierte Schaltung, **dadurch gekennzeichnet, dass** sie Feldeffekttransistoren vom Typ PMOS nach Anspruch 2 und vom Typ NMOS nach Anspruch 1 umfasst.
